Europäisches Patentamt

European Patent Office

Office européen des brevets

(19)

(11) Veröffentlichungsnummer: **0 259 724**
**B1**

(12) **EUROPÄISCHE PATENTSCHRIFT**

(45) Veröffentlichungstag der Patentschrift:
22.11.90

(51) Int. Cl.⁵: **H02K 29/08**

(21) Anmeldenummer: 87112552.2

(22) Anmeldetag: 28.08.87

(54) Leiterplatte.

(30) Priorität: **12.09.86 DE 3631106**

(43) Veröffentlichungstag der Anmeldung:
**16.03.88 Patentblatt 88/11**

(45) Bekanntmachung des Hinweises auf die Patenterteilung:
**22.11.90 Patentblatt 90/47**

(84) Benannte Vertragsstaaten:
**DE NL**

(56) Entgegenhaltungen:
EP-A- 0 152 508
DE-U- 8 527 157

PATENT ABSTRACTS OF JAPAN, Band 7, Nr. 76 (E-167)
[1221], 30. März 1983; & JP-A-58 3556

(73) Patentinhaber: **Siemens Aktiengesellschaft,
Wittelsbacherplatz 2, D-8000 München 2(DE)**

(72) Erfinder: **Schmidt, Helmut, Unterer Weinberg 44,
D-8701 Reichenberg(DE)**
Erfinder: **Grecksch, Ernst, Dr. Dipl.-Phys.,
Konrad-Adenauer-Strasse 47, D-8702 Estenfeld(DE)**

## Beschreibung

Die Erfindung bezieht sich auf eine Leiterplatte gemäß Oberbegriff des Anspruchs 1; eine derartige Leiterplatte ist durch das DE-GM 85 27 157 bekannt.

Im bekannten Fall des DE-GM 85 27 157 sind auf einer am Stator eines Außenläufermotors befestigten Leiterplatte die Hallwandler in engem axialen Abstand zu den Stirnseiten der Rotormagnete angeordnet, derart daß bei deren Rotation in den Hallwandlern lage- bzw. drehzahlabhängige Signalspannungen erzeugt werden, die z.B. einer nachfolgenden Motorsteuerung zugeführt werden. Die Hallwandler sind zum Teil versenkt in Aussparungen der mit Leiterbahnen bedruckten Leiterplatte gehaltert; die aus den Hallwandlern an ihrer einen Stirnseite heraustretenden Anschlußstifte verlaufen zunächst oberhalb und parallel zu der einen Oberfläche der Leiterplatte, sind dann mit ihren abgewinkelten Enden durch Anschlußstift-Einzelbohrungen der Leiterplatte durch- und auf der anderen, mit den aufgedruckten Leiterbahnen versehenen Oberfläche in Anschlußaugen eingesteckt und durch Lötung elektrisch kontaktiert.

Durch die EP-A 0 152 508 ist ein Axialfluß-Motor (Pancake-Motor) bekannt, bei dem zwischen den Rotormagneten und den Hallwandlern die gesamte Ständerwicklung angeordnet ist. Die Hallwandler sind entweder (pior art) in einer Aussparung einer Leiter-Trägerplatte mit oberhalb dieser radial verlaufenden Schaltbeinen oder (neue Lösung) in einer Aussparung des Ständerjoches mit zunächst axial aus den Hallwandlern verlaufenden und dann radial abgelagerten Schaltbeinen angeordnet.

Gemäß Aufgabe vorliegender Erfindung soll die axiale Bauhöhe der Leiterplatte mit den daran gehalterten elektrischen Bauteilen, insbesondere im Sinne eines möglichst geringeren axialen Abstandes zwischen den Stirnseiten der Rotormagnete und der gegenüberliegenden Oberfläche der Leiterplatte mit den daran gehalterten, von den Rotormagneten zu beeinflussenden Hallwandlern, bei gleichzeitig vereinfachter Fertigung und erhöhter Betriebssicherheit verringert werden.

Die Lösung der gestellten Aufgabe ist bei einer Leiterplatte der eingangs genannten Art erfindungsgemäß durch die Lehre des Anspruchs 1 möglich; die Gegenstände der Unteransprüche kennzeichnen vorteilhafte Ausgestaltungen der Erfindung.

Die erfindungsgemäße Konstruktion einer Leiterplatte erlaubt einerseits die vollständige Versenkung der Bauteile, insbesondere der Hallwandler, in die Aussparungen der Trägerplatte und andererseits die einfache geradlinige und raumsparende Verlegung der Anschlußbeine der Hallwandler im Bereich der Aussparungen der Trägerplatte, wobei ihre Kontaktierung durch lediglich einfaches Hochbiegen der freien Enden und das einfache Einstecken dieser Enden in die darüber liegenden Anschlußaugen der die Aussparung in der Trägerplatte in diesem Bereich überdeckenden Leiterfolie möglich ist.

Wird nach einer Ausgestaltung der Erfindung auch die Leiterfolie im Bereich des eigentlichen Hallwandlers ausgespart, so kann dieser auch in die axiale Tiefe der Leiterfolie im Sinne einer weiteren Verringerung der axialen Bauhöhe hineinversenkt werden. Zweckmäßigerweise ist die Leiterfolie auf die Oberfläche der Trägerfolie aufgeklebt und als flexible Leiterfolie ausgebildet, wobei nach einer weiteren Ausgestaltung der Erfindung die flexible Leiterfolie einstückig in ein äußeres Leiterfolienband übergeht, das die äußeren Zu- und/oder Ableitungen zu der Leiterfolie enthält.

Die Erfindung sowie weitere vorteilhafte Ausgestaltungen der Erfindung werden im folgenden anhand eines schematisch dargestellten Ausführungsbeispiels in der Zeichnung näher erläutert; darin zeigen:

Fig. 1 einen axialen Längsschnitt durch einen zum Antrieb einer Plattenspindel eines Plattenspeicherantriebs vorgesehenen Außenläufermotor;

Fig. 2 eine vorgefertigte, bereits mit aktiven und passiven elektrischen Bauteilen bestückte und an ein äußeres Kabelflachband angeschlossene Leiterplatte vor ihrer statorstirnseitigen Motormontage;

Fig. 3 einen Teilschnitt durch die Leiterplatte gemäß Fig.2 im Bereich eines erfindungsgemäß gehalterten und kontaktierten Hallwandlers.

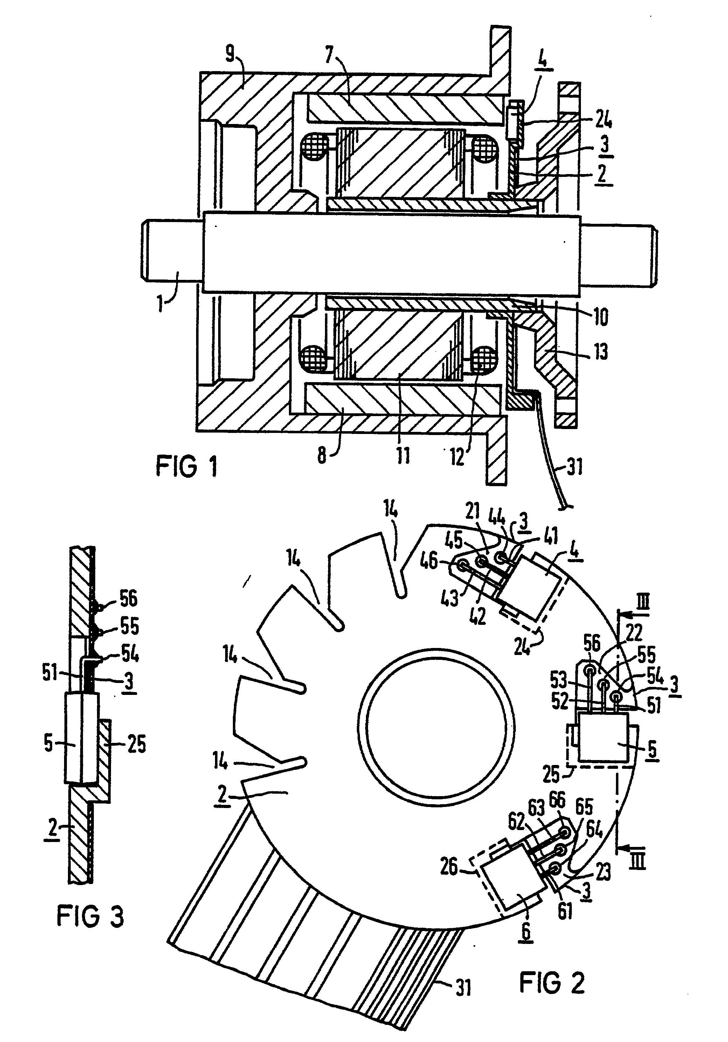

Fig. 1 zeigt in einem axialen Längsschnitt einen Außenläufermotor, der eine am linken Ende mit der Rotorwelle 1 fest verbundene Plattenspindel 9 eines Plattenspeichers antreibt. Die Rotorwelle 1 ist in hier nicht näher dargestellter Weise beidseitig drehbar gelagert und zwischen dieser Lagerung von einer Innenhülse 10 umgeben, auf deren Lagerumfang das Statorblechpaket 11 mit der Statorwicklung 12 aufgedrückt ist. Das rechte Ende der Innenhülse 10 wird von einem Befestigungsflansch 13 aufgenommen, mit dem der gesamte PlattenspeicherAntrieb. in einem Datenverarbeitungsgerät gehalten wird. An der inneren Umfangsfläche der als Läuferglocke des Außenläufermotors ausgebildeten Plattenspindel 9 sind radial dem Statorblechpaket 11 gegenüberliegend Rotormagnete angeordnet, von denen in Fig.1 zwei Rotormagnete 7,8 im Schnitt sichtbar sind.

Auf dem rechten Ende der Innenhülse 10 ist eine in Fig.2,3 näher dargestellte Trägerplatte 2 befestigt, die sich radial bis vor die rechten freien Stirnseiten der Rotormagnete 7,8 erstreckt. Auf der nach außen liegenden Stirnseite der Trägerplatte 2 ist eine flexible Leiterfolie 3 mit einem äußeren Leiterfolienband 31 befestigt, das die äußeren Zu- und Ableitungen zu der Leiterfolie 3 enthält.

Die Trägerfolie ist über ihren Umfang mit Aussparungen 21-23 zur Aufnahme und Halterung von Hallwandlern 4-6 derart versehen, daß die Hallwandler 4-6 in möglichst geringem axialen Abstand zu den rechten freien Stirnseiten der Rotormagnete 7,8 angeordnet werden können.

Die aus der einen seitlichen Stirnseite herausragenden Anschlußbeine 41-43 bzw. 51-53 bzw. 61-63 der Hallwandler 4 bzw.5 bzw.6 verlaufen in den Aussparungen 21-23 der Trägerplatte 2 jeweils zunächst ungeknickt in Längsrichtung der Trägerplatte 2 bis zu ihren einfach abgewinkelten freien Enden unerhalb der Anschlußaugen 44-46 bzw. 54-56 bzw. 64-66 der die Aussparungen 21-23 der Trägerplatte 2 in diesem Bereich überdeckenden Leiterfolie 3. Die abgewinkelten, durchgesteckten Enden der Anschlußbeine 41-43 bzw. 51-53 bzw. 61-63 sind in üblicher Weise durch Lötpunkte mit ihren zu den Anschlußaugen geführten Leiterbahnen der Leiterfolie 3 elektrisch kontaktiert.

Am Umfang der Leiterplatte vorgesehene randseitig trichterförmig erweiterte Radialschlitze 14 dienen in hier nicht näher gezeigter Weise zur vorteilhaften Ein- und Durchfädelung von Wicklungsenden der Statorwicklung 12 von der statorwicklungsseitigen Rückseite der Leiterplatte zu deren mit der Leiterfolie und mit Anschlußaugen für die Statorwicklungsenden versehenen Vorderseite.

Als äußere Schutzabdeckung für die in den Aussparungen fixierten Hallwandler sind jeweils an die Trägerplatte 2 Abdeckkappen 24-26 angeformt, welche die Hallwandler 4-6 jeweils an ihrer den Rotormagneten 7,8 axial abgewandten Unterseite teilweise abdecken.

Die Oberseite der Hallwandler 4-6 verläuft aufgrund der erfindungsgemäß ausgebildeten Leiterplatte und der erfindungsgemäßen Anordnung und Kontaktierung der Hallwandler in den Aussparungen der Trägerplatte in einer Ebene zu der den Stirnflächen der Rotormagnete 7,8 zugewandten Oberfläche der Trägerplatte 2, so daß die Hallwandler 4-6 in engstem axialen Abstand zu den gegenüberliegenden Stirnseiten der Rotormagnete 7,8 angeordnet werden können.

## Patentansprüche

1. Leiterplatte am Stator (11) eines Radialfluß-Außenläufermotors (Inhub-Motor) mit in engem stirnseitigen axialen Abstand zu den Rotormagneten (7, 8) in Aussparungen (21-23) gehaltenen und mit Leiterbahnen kontaktierten Hallwandlern (4-6), gekennzeichnet durch folgende Merkmale:
   a) Die Leiterplatte besteht zumindest aus einer Trägerplatte (2) mit Aussparungen (21-23) jeweils im Bereich der Hallwandler (4-6) und deren Anschlußbeine (41-43 bzw.51-53 bzw.61-63) und aus einer auf der Oberfläche der Trägerplatte (2) befestigten Leiterfolie (3), die die Aussparungen (21-23) jeweils überdeckt und dort mit Anschlußaugen (44-46 bzw. 54-56 bzw.64-66) für die Anschlußbeine der Hallwandler versehen ist;
   b) die Hallwandler sind jeweils in den Aussparungen angeordnet und ihre ansonsten in der Ebene der Aussparungen verlaufenden Anschlußbeine sind zu den Anschlußaugen hin abgebogen.

2. Leiterplatte nach Anspruch 1, gekennzeichnet durch folgendes Merkmal:
   c) die Leiterfolie (3) ist jeweils im Bereich des eigentlichen Hallwandlers (4 bzw.5 bzw.6) ebenfalls mit einer Aussparung versehen.

3. Leiterplatte nach Anspruch 1 und/oder 2, gekennzeichnet durch folgendes Merkmal:
   d) an seiner den Rotormagneten (7,8) abgekehrten Unterseite sind die Hallwandler (4-6) jeweils durch eine Abdeckkappe (24-26) nach außen geschützt.

4. Leiterplatte nach Anspruch 3, gekennzeichnet durch folgendes Merkmal:
   e) die Abdeckkappen (24-26) sind einstückig an die Trägerplatte (2) mitangeformt.

5. Leiterplatte nach einem der Ansprüche 1-4, gekennzeichnet durch folgendes Merkmal:
   f) die Leiterfolie (3) ist auf die Oberfläche der Trägerplatte (2) aufgeklebt.

6. Leiterplatte nach einem der Ansprüche 1-5, gekennzeichnet durch folgendes Merkmal:
   g) als Leiterfolie (3) ist eine flexible, mit Leiterbahnen versehene Klebefolie vorgesehen.

7. Leiterplatte nach einem der Ansprüche 1-6, dadurch gekennzeichnet, daß die von der Trägerplatte (2) aufgenommene Leiterfolie (3) außerhalb der Trägerplatte (2) einstückig in ein äußeres Leiterfolienband (31) übergeht.

## Claims

1. A printed circuit board on the stator (11) of a radial flow external-rotor motor (Inhubmotor) with Hall generators (4–6) held with a narrow end face axial separation from the rotor magnets (7, 8) in recesses (21–23) and contacted with printed conductors, characterised by the following features:
   a) the printed-circuit board consists of at least one carrier plate (2) with respective recesses (21–23) in the region of the Hall generators (4–6) and the terminal legs thereof (41–43 or 51–53 or 61–63) and of a conductor film (3) secured on the surface of the carrier plate (2), which covers the recesses (21–23) in each case and is provided there with terminal eyes (44–46 or 54–56 or 64–66) for the terminal legs of the Hall converters;
   b) the Hall generators are arranged in the respective recesses and their terminal legs extending otherwise in the plane of the recesses are deflected to the terminal eyes.

2. A printed circuit board according to claim 1, characterised by the following feature:
   c) the conductor film (3) is also provided in each case with a recess in the region of the actual Hall generator (4 or 5 or 6).

3. A printed circuit board according to claim 1 and/or 2, characterised by the following features:
   d) on their lower sides turned away from the rotor magnets (7, 8) the Hall generators (4–6) are protected outwards in each case by a cover cap (24–26).

4. A printed circuit board according to claim 3, characterised by the following feature:
   e) the cover caps (24–26) are pre-formed in one piece on the carrier plate (2).

5. A printed circuit board according to one of claims 1–4, characterised by the following feature:
   f) the conductor film (3) is stuck on the surface of the carrier plate (2).

6. A printed circuit board according to one of claims 1–5, characterised by the following feature:
   g) as conductor film (3) a flexible adhesive film is provided with printed conductors.

7. A printed circuit board according to one of claims 1–6, characterised in that the conductor film (3) carried by the carrier plate (2) outside the carrier plate (2) passes over in one piece into an outer conductor film band (31).

**Revendications**

1. Plaquette à voies conductrices sur le stator (11) d'un moteur à rotor extérieur et à flux radial (moteur dit in-hub), avec des transducteur de Hall (4–6) maintenus dans des ouvertures (21–23) à une distance axiale étroite par rapport aux aimants rotoriques (7, 8) et reliés électriquement avec des pistes conductrices, caractérisée par les particularités suivantes:

a) La plaquette à circuits imprimés est constituée par une plaquette de support ( 2 ) comportant des ouvertures ( 21–23 ) prévues respectivement dans la zone des transducteurs de Hall (4–6) et les pattes de raccordement (41–43; 51–53–61–63) de ces derniers, et par une feuille à voies conductrices (3) qui est fixée à la surface de la plaque de support (2) en recouvrant les ouvertures respectives (21–23) et qui y est pourvue d'oeillets de raccordement (44–45; 54–56; 64–66) pour les pattes de raccordement des transducteurs de Hall;

b) les transducteurs de Hall sont disposés respectivement dans les ouvertures, et leurs pattes de raccordement, normalement situées dans le plan des ouvertures, sont coudées en direction des oeillets de raccordement.

2. Plaquette à voies conductrices selon la revendication 1, caractérisée par la particularité suivante:

c) la feuille à pistes conductrice (3) est également pourvue d'ouvertures situées respectivement dans la zone des transducteurs de Hall proprement dits (4, 5, 6).

3. Plaquette à voies conductrices selon la revendication 1 et/ou 2, caractérisée par la particularité suivante:

d) à leurs côtés inférieurs éloignés des aimants rotoriques (7, 8), chaque transducteur de Hall (4–6) est protégé vers l'extérieur par un capot de couverture (24–26).

4. Plaquette à voies conductrices selon la revendication 3, caractérisée par la particularité suivante:

e) les capots de couverture (24–26) sont conformés d'une pièce avec la plaquette de support (2).

5. Plaquette à voies conductrices selon l'une des revendications 1–4, caractérisée par la particularité suivante:

f) la feuille à voies conductrices (3) est collée à la surface de la plaque de support (2).

6. Plaquette à voies conductrices selon l'une des revendications 1–5, caractérisée par la particularité suivante:

g) comme feuille à voies conductrices (3), il est prévu une feuille adhésive flexible, pourvue de voies conductrices.

7. Plaquette à voies conductrices selon l'une des revendications 1–6, caractérisée par le fait que la feuille à voies conductrices (3) qui est reçue par la plaque de support (2) se poursuit d'une pièce et à l'extérieur de la plaque de support (2) par une extérieure de feuille à voies conductrices (31).

FIG 1

FIG 2

FIG 3